# EUROPÄISCHE PATENTSCHRIFT

(11) **EP 3 933 946 B1**
(45) Veröffentlichungstag und Bekanntmachung des Hinweises auf die Patenterteilung: **29.01.2025**
(21) Anmeldenummer: 20183520.4
(22) Anmeldetag: 01.07.2020
(51) Int. Cl.: H10N 10/17, H10N 10/01

(54) **VERFAHREN ZUR HERSTELLUNG EINES THERMOELEKTRISCHEN MODULS UND THERMOELEKTRISCHES MODUL ALS PRESSVERBAND**
METHOD FOR MANUFACTURING A THERMOELECTRIC MODULE AND THERMOELECTRIC MODULE AS A PRESS BAND
PROCÉDÉ DE FABRICATION D'UN MODULE THERMOÉLECTRIQUE ET MODULE THERMOÉLECTRIQUE EN TANT QU'EMMANCHEMENT À FORCE

(43) Veröffentlichungstag der Anmeldung: 05.01.2022
(73) Patentinhaber: Fraunhofer-Gesellschaft zur Förderung der angewandten Forschung e.V., 80686 München (DE)
(72) Erfinder: SCHÄFER-WELSEN, Olaf, 79379 Müllheim (DE); VETTER, Uwe, 79410 Badenweiler (DE); VERGEZ, Marc, 79115 Freiburg (DE); KÖNIG, Jan, 79112 Freiburg (DE)
(74) Vertreter: LBP Lemcke, Brommer & Partner Patentanwälte mbB

(56) Entgegenhaltungen:
- DE-A1- 102009 058 948
- DE-A1- 102010 034 708
- DE-A1- 102015 107 164
- DE-B4- 102010 061 247
- JP-A- S61 254 082
- KR-A- 20140 125 628
- US-A- 3 601 887

## Beschreibung

Die Erfindung betrifft ein Verfahren zur Herstellung eines thermoelektrischen Moduls gemäß dem Oberbegriff des Anspruchs 1, ein thermoelektrisches Modul gemäß dem Oberbegriff des Anspruchs 9 sowie einen Wärmetauscher gemäß dem Oberbegriff des Anspruchs 19, einen thermoelektrischen Generator gemäß dem Oberbegriff des Anspruchs 20, eine Kühlvorrichtung gemäß dem Oberbegriff des Anspruchs 21 und eine Verwendung gemäß dem Oberbegriff des Anspruchs 22.

Thermoelektrische Module werden unter anderem als Peltier-Module zur Kühlung und in thermoelektrischen Generatoren für die Verstromung von Abwärme eingesetzt. Potentiell nutzbare Abwärme fällt in vielen Bereichen des täglichen Lebens, wie beispielsweise im Verkehr, im Haushalt oder in der Industrie an. Über thermoelektrische Generatoren kann die Abwärme in elektrische Energie umgewandelt werden.

Die Thermoelektrik basiert auf dem Einsatz thermoelektrischer Materialien, die den Seebeck-Effekt zeigen. Mittels dieser Materialien kann bereits aus kleinen Temperaturdifferenzen Strom erzeugt werden. Aufgrund des Seebeck-Effekts entsteht in einem Stromkreis aus zwei elektrischen Leitern aus thermoelektrischem Material bei einer Temperaturdifferenz zwischen den Kontaktstellen eine elektrische Spannung durch Thermodiffusionsströme in dem thermoelektrischen Material. Üblicherweise werden hierzu Halbleitermaterialien eingesetzt, da diese einen ausgeprägten Seebeck-Effekt zeigen und somit höhere Umwandlungswirkungsgrade erreichbar sind.

Entscheidend ist sowohl bei der Realisierung der thermoelektrischen Generatoren als auch bei Kühlvorrichtungen, das thermoelektrische Modul in den Wärmetauscher zu integrieren. Aus dem Stand der Technik bekannt sind planare, thermoelektrische Module, die beispielsweise mit Finnen-Wärmetauschern bzw. Rippenplatten-Wärmetauscher eingesetzt werden, die auf die planaren thermoelektrischen Module aufgedrückt werden. Nachteilig an Rippenplattenwärmetauschern ist, dass sie aufgrund ihrer geringen Strömungskanäle zu Fouling und Versottung neigen. Sie können nahezu nicht mechanisch gereinigt werden und erfordern andere Reinigungsverfahren, was sie wartungsintensiv macht. Solche Wärmetauscher werden daher oft schon als Einwegprodukte konzipiert. Die lange Lebensdauer thermoelektrischer Module und der nahezu wartungsfreie Betrieb können in dieser Kombination ihre Vorteile nicht entfalten.

Der Aufbau thermoelektrischer Generatoren ist aus dem Stand der Technik bekannt und umfasst üblicherweise eine Heißseite mit einem Heißseitenreservoir, einen oder mehrere Wärmeübertrager sowie eine Kaltseite mit einem Kaltseitenreservoir.

Der thermoelektrische Wärmetauscher umfasst üblicherweise Fluid-Zuführungen und Fluidabführungen zu Heißseite und Kaltseite sowie ein oder mehrere thermoelektrische Module.

Die thermoelektrischen Module umfassen üblicherweise Wärmeübertrager sowie mehrere thermoelektrische Grundelemente aus elektrisch verbundenen thermoelektrischen Materialien. Die thermoelektrischen Materialien sind üblicherweise elektrisch in Reihe und thermisch parallelgeschaltet.

Aus dem Stand der Technik ist es bekannt, thermoelektrisch wirksame Elemente auf Rohre aufzuschweißen und/oder zu verlöten. Aus der DE 10 2010 061 247 B4 ist ein thermoelektrischer Generator bekannt, bei dem thermoelektrische Module in einem festen Verbund mittels Lötverfahren oder Laserschweißverfahren hergestellt werden.

Aus dem Stand der Technik ist aus der DE 10 2015 107 164 A1 ein thermoelektrischer Generator bekannt. Der thermoelektrische Generator umfasst ein Ausgleichselement aus Naturmaterial, dass das den thermoelektrischen Generator gegenüber der Umgebung thermisch und akustisch isoliert. Alternativ ist aus der DE 10 2009 058 948 A1 ein thermoelektrischer Generator und ein Verfahren zur Herstellung eines thermoelektrischen Generators bekannt, bei der in einem Pressverband Ausgleichselemente vorgesehen sind und ein Pressverband mittels einer Federstruktur erzeugt wird.

Diese Herstellungsverfahren sind aufwendig und kostenintensiv. Weiter nachteilig ist, dass die so hergestellten thermoelektrischen Generatoren aufgrund der Temperaturschwankungen starken mechanischen Belastungen durch Materialausdehnungen ausgesetzt sind. Dies führt zu einem schnellen Verschleiß.

Der Erfindung liegt daher die Aufgabe zugrunde, ein einfaches und kostengünstiges Verfahren zur Herstellung thermoelektrischer Module sowie ein entsprechendes thermoelektrisches Modul vorzuschlagen, die vergleichsweise unempfindlich gegen thermische Belastungen sind.

Gelöst wird diese Aufgabe durch ein Herstellungsverfahren gemäß Anspruch 1 sowie durch ein thermoelektrisches Modul gemäß Anspruch 9 sowie einen Wärmetauscher gemäß Anspruch 19, einen thermoelektrischen Generator gemäß dem Anspruch 20, eine Kühlvorrichtung gemäß Anspruch 21 und eine Verwendung gemäß Anspruch 22.

Bevorzugte Ausgestaltungen des erfindungsgemäßen Verfahrens finden sich in den Ansprüchen 2 bis 8. In den Ansprüchen 10 bis 18 finden sich bevorzugte Ausgestaltungen des thermoelektrischen Moduls. Hiermit wird der Wortlaut sämtlicher Ansprüche explizit per Referenz in die Beschreibung einbezogen. Das erfindungsgemäße Herstellungsverfahren zur Herstellung eines thermoelektrischen Moduls aus zumindest einem Innenrohr und einem Außenrohr und zumindest zwei thermoelektrischen Grundelementen umfasst, wie an sich bekannt, die folgenden Verfahrensschritte:
A Bereitstellen zumindest eines Innenrohrs,
B Bereitstellen des Außenrohrs,
C Bereitstellen der thermoelektrischen Grundelemente außerhalb des Innenrohrs und/oder innerhalb des Außenrohrs,

Wesentlich ist, dass in einem Verfahrensschritt C0 zumindest eine erste plastisch oder elastisch verformbare Funktionsschicht zwischen Innenrohr und thermoelektrischen Grundelementen und eine zweite plastisch oder elastisch verformbare Funktionsschicht zwischen thermoelektrischen Grundelementen und Außenrohr aufgebracht wird und die thermoelektrischen Grundelemente in Verfahrensschritt C mit ihrer Längserstreckung parallel zu der Längserstreckung des Innenrohrs in Wirkverbindung mit der Funktionsschicht angeordnet werden, und dass in einem Verfahrensschritt D nach dem Verfahrensschritt C0 das Innenrohr aufgeweitet wird, sodass durch das Aufweiten des Innenrohrs ein Pressverband aus Innenrohr, Funktionsschichten, thermoelektrischen Grundelementen und Außenrohr entsteht.

Die Erfindung ist in der Erkenntnis der Anmelderin begründet, dass durch den Einsatz einer plastisch und/oder elastisch verformbaren Funktionsschicht thermoelektrische Module mittels eines Pressverbands rein kraftschlüssig, d. h. ohne anfällige stoffschlüssige Verbindungen, hergestellt werden können.

"Ohne eine stoffschlüssige Verbindung" bezieht sich im Rahmen dieser Beschreibung auf den wesentlichen Zusammenhalt der Komponenten des Pressverbands, nämlich zumindest Innenrohr, Funktionsschicht, thermoelektrische Grundelemente und Außenrohr. Stoffschlüssige Verbindungen in Form von Lötstellen für die Kontaktierung der thermoelektrischen Grundelemente oder für die Kontaktierung oder Isolierung der Halbleiterelemente oder ähnliches sind dadurch nicht ausgeschlossen.

Das erfindungsgemäße Verfahren zur Herstellung thermoelektrischer Module unterscheidet sich somit in wesentlichen Punkten von vorbekannten Verfahren: Zwischen den thermoelektrischen Grundelementen, d. h. den thermoelektrischen Materialien, die über elektrisch leitende Brücken verbunden sind, und dem Innenrohr ist eine plastisch oder elastisch verformbare Funktionsschicht vorgesehen. Zusätzlich ist zwischen thermoelektrischen Grundelementen und Außenrohr eine plastisch oder elastisch verformbare Funktionsschicht vorgesehen. Durch das Aufweiten des Innenrohrs werden Innenrohr, Funktionsschichten, thermoelektrische Grundelemente und Außenrohr mittels eines Pressverbands, d. h. durch einen Kraftschluss, miteinander verbunden. Diese Komponenten sind somit lösbar miteinander verbunden. Hierdurch ergibt sich der Vorteil, dass keine anfälligen stoffschlüssigen Verbindungen eingesetzt werden. Scherkräfte aufgrund axialer Längenänderungsunterschiede, typischerweise aufgrund thermischer Ausdehnung durch die Temperaturunterschiede von Heißseite und Kaltseite thermoelektrischer Module bedingt, werden durch die elastischen bzw. plastischen Zwischenschichten ausgeglichen. Durch die elastischen und/oder plastischen Eigenschaften können die Funktionsschichten dauerhaft oder zeitweise thermischen oder mechanischen Einflüssen folgen, indem sie beispielsweise ein Fließverhalten zeigen oder elastische Verformungen tolerieren. Dies ermöglicht einen sehr flexiblen Einsatz der thermoelektrischen Grundelemente sowohl mit einer außenliegenden als auch einer innenliegenden Heißseite eines Wärmetauschers.

Weiter vorteilhaft ist, dass auch Materialien mit einer starken Längenänderung, wie zum Beispiel Formgedächtnislegierungen als Teile des Verbunds, beispielsweise als Innenrohr und/oder Außenrohr, eingesetzt werden könnten.

Erfindungsgemäß wird jeweils eine plastisch oder elastisch verformbare Funktionsschicht zwischen Innenrohr und thermoelektrischen Grundelementen und zwischen thermoelektrischen Grundelementen und Außenrohr aufgebracht.

In einer bevorzugten Ausführungsform der Erfindung wird vor dem Verfahrensschritt D zumindest eine elektrisch isolierende Funktionsschicht zwischen Innenrohr und thermoelektrische Grundelemente und/oder zwischen thermoelektrische Grundelemente und Außenrohr eingebracht. Der Kraftschluss des Pressverbands umfasst somit die Komponenten Innenrohr, elastische bzw. plastischen Funktionsschichten, elektrisch isolierende Funktionsschichten, thermoelektrische Grundelemente und Außenrohr. Diese Komponenten sind somit lösbar, ohne stoffschlüssige Verbindungen miteinander verbunden.

Die elektrische isolierende Funktionsschicht bzw. die elektrisch isolierenden Funktionsschichten können beispielsweise als rohrförmige Folien eingeschoben werden. Alternativ ist auch eine Beschichtung der plastisch oder elastisch verformbaren Funktionsschicht mit isolierendem Material denkbar.

Durch die elektrisch isolierende Funktionsschicht ergibt sich der Vorteil, dass in einfacher Art und Weise eine Isolierung der thermoelektrischen Grundelemente erreicht werden kann.

In einer alternativen Ausführungsform der Erfindung wird auf die thermoelektrischen Grundelemente eine elektrisch isolierende Schicht aufgebracht. Dies kann beispielsweise in Form von Isolationslack auf den Verbindungsbrücken der thermoelektrischen Materialien oder in Form einer vollflächigen isolierenden Schicht, beispielsweise einer Keramikschicht, erfolgen. Der Kraftschluss des Pressverbands umfasst somit die Komponenten Innenrohr, elastische bzw. plastische Funktionsschichte, thermoelektrische Grundelemente und Außenrohr. Diese Komponenten sind somit lösbar, ohne stoffschlüssige Verbindungen miteinander verbunden. Die elektrisch isolierende Schicht ist hingegen stoffschlüssig mit den thermoelektrischen Grundelementen verbunden.

In einer bevorzugten Ausführungsform erfolgt die Isolierung der thermoelektrischen Grundelemente mittels einer Kombination aus isolierender Funktionsschicht auf der einen Seite und isolierender Beschichtung als Teil der Grundelemente auf der anderen Seite.

In einer bevorzugten Ausführungsform des erfindungsgemäßen Verfahrens ist die Presskraft im Verfahrensschritt D an eine maximale Betriebstemperatur des thermoelektrischen Moduls angepasst. Insbesondere bevorzugt ist der Pressverband ausgelegt, eine thermische Ausdehnung des Innenrohrs und/oder des Außenrohrs zu kompensieren bzw. auszuhalten. Da durch das lokale Erwärmen entweder des Innenrohrs oder des Außenrohrs durch die Heißseite thermische Änderungen der Abmessungen von Außenrohr und Innenrohr auftreten können, üblicherweise Längenänderungen bzw. radiale Ausdehnung, besteht die Gefahr, dass der Pressverband gelockert wird. Dies kann zu einer verschlechterten thermischen Leitfähigkeit führen oder sogar die einzelnen Komponenten verrutschen bzw. auseinanderfallen lassen. Vorteilhafterweise ist der Pressverband somit ausgelegt, dass selbst bei einer maximalen Betriebstemperatur der Kraftschluss erhalten bleibt.

Üblicherweise herrschen Temperaturen von ungefähr 15°C im Innenrohr und im Bereich von bis zu 220°C im Außenbereich außerhalb des Außenrohrs. Die üblicherweise eingesetzten thermoelektrischen Halbleitermaterialien sowie das Lot für die Lötverbindungen der Halbleitermaterialien mit den verbindenden, elektrisch leitenden Brücken tolerieren maximale Betriebstemperaturen im Bereich von 230 °C. Es ist daher zweckmäßig, den Pressverband derart auszulegen, dass der Anpressdruck Längenänderungen, die bei den genannten maximalen Betriebstemperaturen erfolgen können, toleriert.

Es liegt jedoch ebenfalls im Rahmen der Erfindung, Materialgruppen einzusetzen, wie z.B. Halb-Heusler Legierungen, die bei weitaus höheren Temperaturen verbunden werden können. Bevorzugt wird bei der Verwendung dieser Materialien der Anpressdruck bei der Herstellung des Pressverbandes entsprechend angepasst, um die entsprechend höheren maximalen Betriebstemperaturen tolerieren zu können.

Vorzugsweise erfolgt die Verbindung von Innenrohr, Funktionsschichten, thermoelektrischen Grundelementen und Außenrohr somit ohne eine stoffschlüssige Verbindung. "Ohne eine stoffschlüssige Verbindung" bezieht sich auf den wesentlichen Zusammenhalt der Komponenten des Pressverbands. Lötstellen für die Kontaktierung der thermoelektrischen Grundelemente oder für die Kontaktierung oder ähnliches sind dadurch nicht ausgeschlossen.

Außenrohr und Innenrohr sind vorzugweise so ausgebildet, dass diese gleichmäßig aufgeweitet oder geschrumpft werden können, zum Beispiel als Rohre mit kreisförmigem Querschnitt, 4-Kantrohre oder Vielkantrohre oder ovale Rohre, bevorzugt axialsymmetrisch oder radialsymmetrisch.

Das Innenrohr kann in einer besonderen Ausführungsform vor dem Pressfügen aus zwei oder mehrere Materialien bestehen, die durch das Pressfügen und/oder einer Erwärmung einen festkörperbasierten Materialverbund (z.B. Intermetallische Phase oder Legierung) ausbildet. Vorteilhafte Eigenschaften dieses Materialverbundes sind u.a. eine höhere thermische Stabilität, mechanische Festigkeit, angepasste thermische Ausdehnung, bessere Wärmeübertragung, höhere Korrosionsbeständigkeit. Die Materialien können vor dem Pressfügen verschiedene Formen aufweisen: Neben flachen und geriffelten Rohrformen können die Materialien auch als zusammengerollte Folien, Lochbleche, Netze oder als (offenporige) Metallschäumen vorkommen. Es kann auch eine spiralförmige Stange verwendet werden.

In einer bevorzugten Ausführungsform der Erfindung werden in dem Verfahrensschritt C eine Mehrzahl thermoelektrischer Grundelemente gleichmäßig entlang des Umfangs des Innenrohrs angebracht. Vorzugsweise werden diese thermoelektrischen Grundelemente symmetrisch entlang des Umfangs des Innenrohrs angebracht. Insbesondere bevorzugt werden 12 bis 18 thermoelektrische Grundelemente gleichmäßig entlang des Umfangs des Innenrohrs angebracht. Hierdurch erfolgt eine gleichmäßige Abdeckung der Mantelfläche des Innenrohrs mit thermoelektrischen Grundelementen, sodass ein gleichmäßiger Wärmeübertrag erfolgen kann.

Die thermoelektrischen Materialien sind üblicherweise als Würfel, Quader, Prismen oder Zylinder mit gleich großen Oberflächen zur Wärmequelle und Wärmesenke ausgeführt. In einer speziellen Ausführungsform können diese auch als konischer Zylinder oder konischer Quader ausgeführt sein, um eine bestmögliche Leistungsausbeute zu erzielen. Des Weiteren ist es vorteilhaft, wenn die Geometrien der beiden verschiedenen thermoelektrischen Materialien entsprechend ihrer thermoelektrischen Eigenschaften so aneinander angepasst werden, dass die Effizienz und die elektrische Leistungsausbeute maximiert werden. Details sind aus dem Stand der Technik bekannt, siehe Thermoelectric Devices: Influence of the Legs Geometry and Parasitic Contact Resistances on ZT, Angel Fabian-Mijangos and Jaime Alvarez-Quintana, 2018, DOI:
10.5772/intechopen.75790).

Bevorzugt werden die thermoelektrischen Grundelemente miteinander elektrisch verbunden. Allerdings ist es auch möglich, dass jedes thermoelektrische Grundelement einzeln abgegriffen wird. Dies ist jedoch eine deutlich aufwendigere Realisierung. Insbesondere bevorzugt werden die thermoelektrischen Grundelemente in einer Zickzack-Anordnung oder mäanderförmig miteinander elektrisch verbunden. Dazu werden bevorzugt über den Umfang benachbarte thermoelektrische Grundelemente elektrisch so verbunden, dass die Grundelemente entsprechend ihres thermoelektrischen Effekts in Reihe geschaltet sind, d.h. der Strom fließt bei zwei benachbarten Streifen vorzugsweise in entgegengesetzter Richtung.

Die Zwischenräume zwischen den thermoelektrischen Grundelementen sind im einfachsten Fall luftgefüllt. Durch die Luft wird in einfacher und kostengünstiger Art und Weise eine Wärmeisolierung erreicht. Alternativ ist es auch möglich, die Zwischenräume bspw. auszuschäumen für einen schlechten Wärmeübertrag von der Heiß- auf die Kaltseite oder weitgehend zu evakuieren, sodass durch Vakuum ein schlechter Wärmeübertrag entsteht.

In einer bevorzugten Ausführungsform der Erfindung ist die Funktionsschicht mehrschichtig, bevorzugt zumindest zweischichtig aufgebaut, das heißt es wird eine Mehrzahl Funktionsschichten aufgebracht, indem zwischen Innenrohr und thermoelektrischen Grundelementen zumindest eine erste elektrisch isolierende Funktionsschicht und eine zweite plastisch und/oder elastisch verformbare Funktionsschicht aufgebracht wird. Diese Funktionsschichten können separat oder als Schichtverbund ausgebildet sein und können auch weitere Zwischenschichten enthalten. Zwischen thermoelektrischen Grundelementen und Außenrohr kann ebenfalls zumindest eine dritte elektrisch isolierende und eine vierte plastisch oder elastisch verformbare Funktionsschicht aufgebracht werden. Die elektrisch isolierende Funktionsschicht ist auf der Seite der thermoelektrischen Grundelemente angeordnet, da sich diese ansonsten über die plastisch und/oder elastisch verformbare Funktionsschicht elektrisch kurzschließen könnten. Hierdurch ergibt sich der Vorteil, dass die Eigenschaften der Funktionsschichten gezielt gesteuert werden können und insbesondere für den gesamten Schichtaufbau eine gute Wärmeübertragung erreicht werden kann.

In einer bevorzugten Ausführungsform kann die Funktionsschicht eine Beschichtung, eine Folie, oder ähnliches, aber auch die Oberfläche eines Bauteils wie beispielsweise die Oberfläche eines Rohrs sein. Ist beispielsweise das Innenrohr bereits aus einem Kunststoff ausgebildet oder mit einem elektrisch isolierenden Stoff beschichtet, der sich elastisch bzw. plastisch verformen kann, kann auf eine explizite separate Funktionsschicht mit diesen Merkmalen verzichtet werden. Wenn dann die thermoelektrischen Grundelemente so beschaffen sind, dass sie mit geringem thermischen Kontaktwiderstand ans Innenrohr ankoppeln, kann hier auf eine Funktionsschicht verzichtet werden.

Vorzugsweise ist die elektrisch isolierende Funktionsschicht aus Polyimid ausgebildet, bevorzugt als Kapton^{®}-Folie. Die plastisch oder elastisch verformbare Funktionsschicht ist vorzugsweise als Graphitfolie ausgebildet. Alternativ können als elektrisch isolierende Schichten, je nach thermischer Eigenschaft auch für die Heißseite, herkömmliche bekannte Kunststofffolien, isolierende Schutzlacke, Beschichtungen aus Beschichtungsanlagen z.B. SiO₂, Parylene, Keramiken oder isolierende Beschichtungen wie eloxierte Aluminium-Rohre, emaillierte Stahlrohre oder Kupfer mit mehreren Lackschichten eingesetzt werden.

Beispiele für plastische oder elastisch verformbare Funktionsschichten sind Metallschäume, graphitgefüllte Silikone oder Acrylpolymere gefüllt mit wärmeleitendem Keramikpulver.

Viele elektrisch isolierende Funktionsschichten weisen eine schlechte Wärmeleitfähigkeit auf. Die elektrisch isolierenden Funktionsschichten sollten daher möglichst dünn ausgebildet sein. Insbesondere Polyimid-Folien sind elektrisch isolierend, weisen jedoch eine schlechte Wärmeleitfähigkeit auf. Diese Folie sollte daher möglichst dünn ausgebildet sein. Graphitfolien sind elastisch verformbar und weisen eine gute Wärmeleitfähigkeit auf.

In einer bevorzugten Ausführungsform des erfindungsgemäßen Verfahrens werden die thermoelektrischen Grundelemente kontaktiert. Vorzugsweise sind die thermoelektrischen Grundelemente miteinander elektrisch verbunden und es wird eine gemeinsame Kontaktierung für die elektrisch verbundenen thermoelektrischen Grundelemente aufgebracht. Vorzugsweise erfolgt die Kontaktierung erst nach dem Verfahrensschritt D.

Die Aufweitung des Innenrohrs kann durch mechanische, hydraulische und/oder pneumatische Krafteinwirkung und/oder elektromagnetische Umformung erfolgen. Alternativ oder zusätzlich kann auch thermisch eine entsprechende Krafteinwirkung erzielt werden, z. B. durch eine Schrumpfmanschette.

In einer bevorzugten Ausführungsform der Erfindung wird zunächst in einem ersten Verfahrensschritt B das Außenrohr bereitgestellt. Anschließend wird die Funktionsschicht bzw. werden die Funktionsschichten in dem Verfahrensschritt C0 an der Innenseite des Außenrohres aufgebracht. Bevorzugt werden die Funktionsschichten in Form von rohrförmigen Folien eingeschoben.

Im Anschluss werden die thermoelektrischen Grundelemente in dem Verfahrensschritt C, bevorzugt in Form mehrerer Streifen eingeschoben. In einem nächsten Verfahrensschritt A wird das Innenrohr eingeschoben und in dem Verfahrensschritt D aufgeweitet Das Innenrohr ist bevorzugt ebenfalls mit einer Funktionsschicht bzw. Funktionsschichten versehen. Alternativ werden zwischen thermoelektrischen Grundelementen und Innenrohr ebenfalls Funktionsschichten in Form von rohrförmigen Folien eingeschoben

Die erfindungsgemäße Aufgabe wird ebenfalls gelöst durch ein thermoelektrisches Modul mit zumindest einem Innenrohr und einem Außenrohr und zumindest zwei thermoelektrischen Grundelementen.

Wesentlich ist, dass die thermoelektrischen Grundelemente eine Längserstreckung parallel zu der Längserstreckung des Innenrohrs aufweisen und das thermoelektrische Modul zwischen Innenrohr und thermoelektrischen Grundelementen und zwischen thermoelektrischen Grundelementen und Außenrohr zumindest eine plastisch und/oder elastisch verformbare Funktionsschicht aufweist. Weiter sind Innenrohr, Funktionsschichten, thermoelektrische Grundelemente und Außenrohr mittels eines Pressverbands verbunden.

Hierdurch ergibt sich der Vorteil, dass insbesondere Längenänderungen entlang der Längserstreckung der thermoelektrischen Grundelemente, üblicherweise durch Scherkräfte aufgrund von Längenänderungen durch thermische Ausdehnung des Innenrohrs oder des Außenrohrs, von der Funktionsschicht bzw. den Funktionsschichten aufgenommen werden. Die plastisch oder elastisch verformbaren Funktionsschichten weisen Fließeigenschaften auf, sodass die durch die Längenänderung entstehenden Scherkräfte keinen oder einen vergleichsweise deutlich geringeren negativen Einfluss auf den Pressverband haben.

Das erfindungsgemäße thermoelektrische Modul weist ebenfalls die oben beschriebenen Vorteile des erfindungsgemäßen Verfahrens auf und weist vorzugsweise die oben beschriebenen Merkmale des erfindungsgemäßen Verfahrens auf. Vorzugsweise ist das thermoelektrische Modul mit dem erfindungsgemäßen Verfahren hergestellt.

In einer bevorzugten Ausführungsform der Erfindung weist das thermoelektrische Modul zwischen Innenrohr und thermoelektrischen Grundelementen und/oder zwischen thermoelektrischen Grundelementen und Außenrohr zumindest eine elektrisch isolierende Funktionsschicht auf. Der Kraftschluss des Pressverbands umfasst somit die Komponenten Innenrohr, elastische bzw. plastischen Funktionsschichten, elektrisch isolierende Funktionsschichten, thermoelektrische Grundelemente und Außenrohr. Diese Komponenten sind somit lösbar, ohne stoffschlüssige Verbindungen miteinander verbunden.

Die elektrische isolierende Funktionsschicht bzw. die elektrisch isolierenden Funktionsschichten können beispielsweise als Folien ausgebildet sein. Alternativ ist auch eine Beschichtung auf der plastisch oder elastisch verformbaren Funktionsschicht mit isolierendem Material möglich.

Durch die elektrisch isolierende Funktionsschicht ergibt sich der Vorteil, dass in einfacher Art und Weise eine Isolierung der thermoelektrischen Grundelemente erreicht werden kann.

In einer alternativen Ausführungsform der Erfindung weisen die thermoelektrischen Grundelemente zumindest eine elektrisch isolierende Schicht auf. Diese elektrisch isolierende Schicht kann beispielsweise in Form von Isolationslack auf den Verbindungsbrücken der thermoelektrischen Materialien oder in Form einer vollflächigen isolierenden Schicht, beispielsweise einer Keramikschicht, ausgebildet sein. Der Kraftschluss des Pressverbands umfasst somit die Komponenten Innenrohr, elastische bzw. plastische Funktionsschichte, thermoelektrische Grundelemente und Außenrohr. Diese Komponenten sind somit lösbar, ohne stoffschlüssige Verbindungen miteinander verbunden. Die elektrisch isolierende Funktionsschicht ist hingegen stoffschlüssig mit den thermoelektrischen Grundelementen verbunden.

Vorzugsweise sind die Funktionsschichten zumindest zweischichtig aufgebaut, bevorzugt in Form einer elektrisch isolierenden Funktionsschicht und einer plastisch und/oder elastisch verformbaren Funktionsschicht. Mögliche Materialien für die elektrisch isolierende Funktionsschicht sind Polyimide, wie beispielsweise Kapton^{®}-Folien. Mögliche Materialien für die plastisch oder elastisch verformbare Funktionsschicht sind Graphitfolien

Wie bereits zu dem erfindungsgemäßen Verfahren beschrieben, sind die elektrisch isolierenden Funktionsschichten vorzugsweise herkömmliche bekannte Kunststofffolien, isolierende Schutzlacke, Beschichtungen aus Beschichtungsanlagen z.B. SiO₂, Parylene, Keramiken oder Isolierende Beschichtungen wie eloxierte Aluminium-Rohre, emaillierte Stahlrohre oder Kupfer mit mehreren Lackschichten.

Beispiele für plastische oder elastisch verformbare Funktionsschichten sind Metallschäume, graphitgefüllte Silikone oder Acrylpolymere gefüllt mit wärmeleitendem Keramikpulver.

Vorzugsweise ist die elektrisch isolierende Funktionsschicht aus Polyimid ausgebildet, bevorzugt als Kapton^{®}-Folie. Die plastisch und/oder elastisch verformbare Funktionsschicht ist vorzugsweise als Graphitfolie ausgebildet.

Um bei einem übermäßigen Erhitzen des thermoelektrischen Moduls über die maximale Betriebstemperatur ein Auseinanderfallen der Komponenten zu verhindern, können Klebeschichten vorgesehen sein. Diese Klebeschichten sind jedoch nicht wesentlich für die Umsetzung der Erfindung. Bevorzugt sind die Klebeschichten zwischen thermoelektrischen Grundelementen und jeweils angrenzender Funktionsschicht auf der Kaltseite angeordnet. Hierdurch ergibt sich der Vorteil, dass auf der Kaltseite die Klebewirkung besser und dauerhafter ist.

Der Aufbau der thermischen Grundelemente ist aus dem Stand der Technik bekannt Thermoelectric Devices: Influence of the Legs Geometry and Parasitic Contact Resistances on ZT, Angel Fabian-Mijangos and Jaime Alvarez-Quintana, 2018, DOI: 10.5772/intechopen.75790.

Die thermoelektrischen Grundelemente sind aus p- und n-dotierten Halbleiterelementen aufgebaut, die elektrisch leitend miteinander verbunden sind. Üblicherweise werden hier Lötverbindungen eingesetzt.

Für einen möglichst gleichmäßigen Wärmeübertrag ist eine Mehrzahl thermoelektrischer Grundelemente vorgesehen, bevorzugt mehr als zehn thermoelektrische Grundelemente, insbesondere bevorzugt 18 thermoelektrische Grundelemente. Die thermoelektrischen Grundelemente sind gleichmäßig radialsymmetrisch entlang des Umfangs des Innenrohres angebracht. Dadurch ergibt sich eine möglichst gleichmäßige und effiziente Wärmeübertragung.

Die Zwischenräume zwischen den thermoelektrischen Grundelementen sind vorzugsweise mit Luft gefüllt. Die Zwischenräume können alternativ mit Schutzgas, thermischer und elektrischer Isolierung gefüllt sein oder evakuiert sein.

In einer bevorzugten Ausführungsform der Erfindung ist in dem Innenrohr ein Turbulator, insbesondere ein spiralförmiger Turbulator, ein schraubenförmiger Turbulator oder ein links/rechts-verdrehter (L-R twisted) Turbulator vorgesehen. Dadurch ergibt sich ein besserer Wärmeübertrag. Zusätzlich führt der Turbulator zu einer verbesserten mechanischen Stabilität der Anordnung.

Die erfindungsgemäße Aufgabe wird ebenfalls gelöst durch einen Wärmetauscher mit zumindest einem thermoelektrischen Modul, das gemäß einer der oben beschriebenen Ausführungsformen ausgebildet ist. Dies ermöglicht robuste, langlebige Wärmetauscher-Bauformen. Insbesondere ändert sich beim Handling wie zum Beispiel bei der Reinigung der Wärmetauscher gegenüber den bisherigen bekannten Wärmetauschern nichts. Das heißt durch die thermoelektrischen Einbauten entstehen keine zusätzlichen Kosten bei Service und Wartung.

Ein besonderer Vorteil der Erfindung ist, dass der Wärmefluss derart erfolgt, dass eine äußere Heißseite einfacher umsetzbar ist als bei vielen aus dem Stand der Technik bekannten Lösungen: Wenn die Heißseite außen, das heißt außerhalb des Außenrohrs ist, dann wird diese sich in der Regel stärker radial ausdehnen als das kältere Innenrohr. Dabei können insbesondere in den stoffschlüssigen Lotverbindungen sehr hohe Spannungskräfte entstehen, die die Verbindung schädigen bzw. zerstören können.

Umgekehrt sind auftretende Druckkräfte bei einer stärkeren Ausdehnung des Innenrohrs durch eine Heißseite im Innenrohr üblicherweise unkritischer.

Da erfindungsgemäß die entstehenden Kräfte durch die Funktionsschicht aufgefangen oder zumindest reduziert werden, vereinfacht bzw. verbessert die Erfindung die Möglichkeiten für eine Realisierung einer äußeren Heißseite.

Darüber hinaus wird durch die erfindungsgemäße Ausgestaltung einer Überhitzung der Lotstellen auf der Heißseite der thermoelektrischen Grundelemente vorgebeugt für den Fall, dass sich der Wärmeüberträger außen schneller aufheizt als die innenliegenden Komponenten, indem der Anpressdruck bei zu hohen Temperaturen an das äußere Rohr so stark abnehmen wird, dass der Wärmetransport durch Wärmeleitung vom Außenrohr durch die Zwischenschicht zu den Grundelement schlechter wird. Der thermische Kontaktwiderstand wird zunehmen und die Lotstellentemperatur wird degressiv mit der Heißseitentemperatur zunehmen. Der nachlassende Anpressdruck schützt somit die Lotstellen vor Überhitzung

Das erfindungsgemäße Herstellungsverfahren für thermoelektrische Module ist insbesondere zur Herstellung thermoelektrischer Module und Wärmetauscher für die Verstromung von Abwärme geeignet. Mögliche Anwendungsbereiche sind zum Beispiel thermoelektrische Generatoren für Thermen, Kessel, Öfen, die Abwärme-Nutzung bei Schiffen, Lokomotiven oder Fahrzeugen mit Kraftmaschinen. Alternativ können die thermoelektrischen Grundelemente als Peltier-Elemente zur Temperierung von Fluiden, Verbesserung von Kühl- und Wärmepumpenkreisläufen oder als Aktoren eingesetzt werden. Die Erfindung nimmt zwar in Kauf, dass der Wärmeübertrag auf die thermoelektrischen Grundelemente im Vergleich zu aus dem Stand der Technik bekannten Lösungen reduziert ist, profitiert jedoch von deutlich reduzierten Herstellungskosten.

Weitere bevorzugte Merkmale und Ausführungsformen des erfindungsgemäßen Herstellungsverfahrens und des erfindungsgemäßen thermoelektrischen Moduls werden im Folgenden anhand von Ausführungsbeispielen und den Figuren erläutert. Dabei zeigt:
- Figur 1: Schematische Darstellung eines thermoelektrischen Moduls im Schnitt entlang der Längserstreckung der thermoelektrischen Grundelemente;
- Figur 2: Eine Explosionsdarstellung eines thermoelektrischen Moduls;
- Figur 3: Eine schematische Darstellung eines thermoelektrischen Moduls im Querschnitt;

Gleiche Bezugszeichen bezeichnen in den Figuren gleiche oder gleichwirkende Elemente.

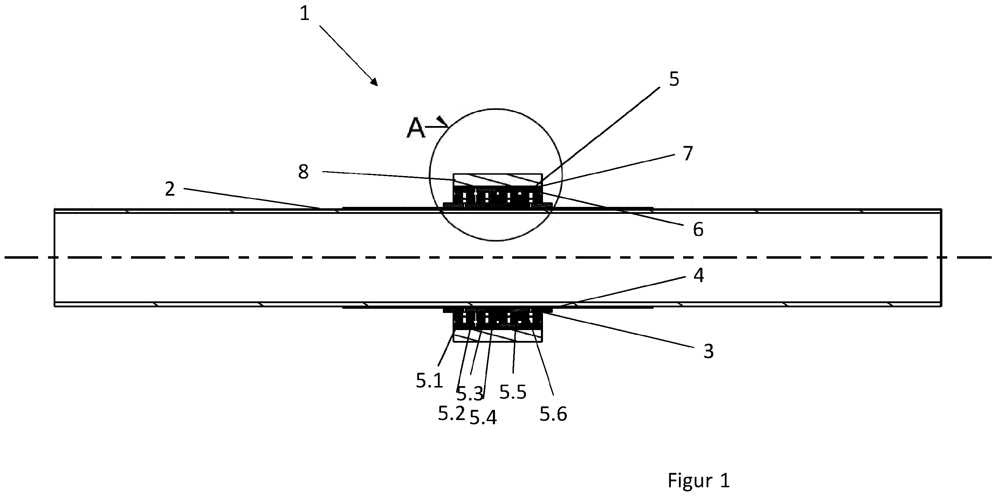

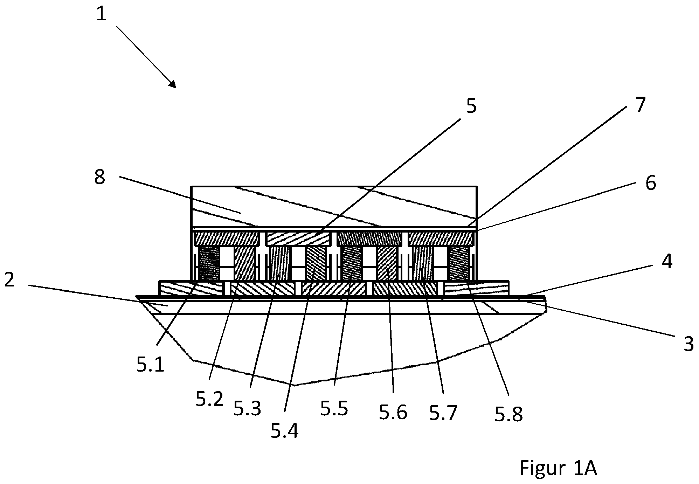

Figur 1 zeigt eine schematische Darstellung eines thermoelektrischen Moduls 1 im Längsschnitt mit Teilabbildung 1A.

Das thermoelektrische Modul 1 umfasst ein Innenrohr 2 und ein Außenrohr 8. Auf dem Innenrohr 2 ist eine Graphitfolie 3 aufgebracht. Die Graphitfolie 3 weist eine Dicke 100 bis 250 Mikrometern auf. Auf der Graphitfolie 3 ist eine Polyimid-Folie 4, vorliegend eine Kapton^{®}-Folie, aufgebracht. Die Kapton^{®}-Folie ist sehr dünn ausgebildet und weist eine Dicke im Bereich von 7 - 30 Mikrometern auf. Auf der Kapton^{®}-Folie sind die thermoelektrischen Grundelemente 5 mit ihrer Längserstreckung parallel zu der Längserstreckung des Innenrohrs 2 aufgebracht. Vorliegend sind 18 thermoelektrische Grundelemente 5 vorgesehen.

Auf den thermoelektrischen Grundelementen 5 ist eine zweite zweischichtige Funktionsschicht vorgesehen, vorliegend in Form einer Polyimid-Schicht 6, vorliegend ebenfalls als Kapton^{®}-Folie ausgebildet, und einer Graphitfolie 7. Auf die Graphitfolie 7 ist das Außenrohr 8 aufgesetzt.

Die thermoelektrischen Grundelemente 5 sind aus thermoelektrischen Halbleitermaterialien ausgebildet, vorliegend BiTe-Legierungen

Die thermoelektrischen Grundelemente 5 weisen jeweils alternierend p- und n-dotierte Halbleiter auf, die über Lötbrücken elektrisch leitend miteinander verbunden sind. Vorliegend sind die thermoelektrischen Grundelemente 5 mit jeweils sechs Halbleiterelementen, drei p-dotierten Halbleiterelementen 5.1, 5.3, 5.5 und drei n-dotierten Halbleiterelementen, 5.2, 5.4, 5.6 ausgebildet. In Umfangsrichtung sind um das Innenrohr 2 mit gleichmäßigem Abstand 18 thermoelektrische Grundelemente 5 aufgebracht. Dadurch ist ein gleichmäßiger Wärmeübertrag gewährleistet.

Die 18 thermoelektrischen Grundelemente 5 sind miteinander elektrisch leitend verbunden und weisen eine gemeinsame Kontaktierung (nicht dargestellt) auf.

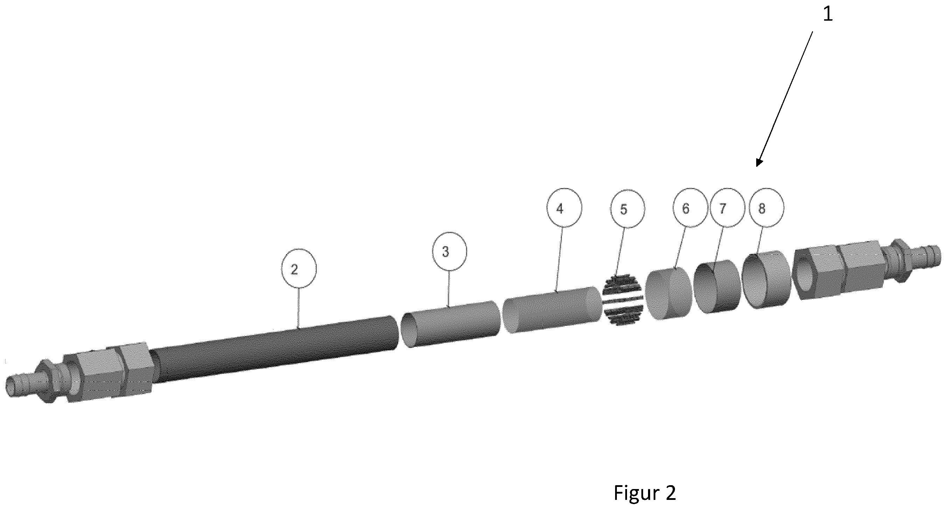

Anhand der Explosionsdarstellung in Figur 2 soll im Folgenden eine Ausgestaltung des erfindungsgemäßen Verfahrens beschrieben werden:
In einem ersten Verfahrensschritt A wird das Innenrohr 2 bereitgestellt.

In dem folgenden Verfahrensschritt C0 werden die elastisch verformbare erste Funktionsschicht, vorliegend eine Graphitfolie 3 und die zweite elektrisch isolierende Funktionsschicht eine Polyimid-Folie 4, vorliegend eine Kapton^{®}-Folie, auf das Innenrohr 2 aufgebracht.

Auf die Polyimid-Folie 4 werden in dem Verfahrensschritt C die thermoelektrischen Grundelemente 5 angebracht. Die thermoelektrischen Grundelemente 5 werden mit ihrer Längserstreckung parallel zu der Längserstreckung des Innenrohrs 2 aufgebracht. Dabei stehen die thermoelektrischen Grundelemente 5 in Wirkverbindung mit insbesondere den Funktionsschichten.

Erste Funktionsschicht und zweite Funktionsschicht sind zusammenwirkend derart aufgebaut, dass eine gute Wärmeleitfähigkeit, d. h. ein guter thermischer Kontakt, zwischen den thermoelektrischen Grundelementen und dem Volumen des Innenrohrs besteht, sodass die Temperaturdifferenz über die Funktionsschicht im Verhältnis zur Temperaturdifferenz über die thermoelektrischen Grundelemente möglichst klein ist.

In einem weiteren werden eine dritte elektrisch isolierende Funktionsschicht sowie eine vierte elastisch verformbare Funktionsschicht, vorliegend eine Kapton^{®}-Folie 6 und eine Graphitfolie 7, auf die thermoelektrischen Grundelemente 5 aufgebracht.

In einem Verfahrensschritt B wird das Außenrohr 8 bereitgestellt und über die beschichteten thermoelektrischen Grundelemente 5 geschoben. Abschließend wird in einem Verfahrensschritt D durch das Aufschrumpfen des Außenrohrs 8 ein Pressverband aus Innenrohr 2, Funktionsschichten 3, 4, 6, 7, thermoelektrischen Grundelementen 5 und Außenrohr 8 hergestellt.

Vorliegend wird der Pressverband durch das Aufweiten des Innenrohrs 2 hergestellt. Dabei ist die Presskraft derart ausgelegt, dass die Längenänderung durch die thermische Ausdehnung des Außenrohrs im Betriebszustand von der Presskraft kompensiert wird.

Vorteilhafterweise werden somit für die Verbindung der genannten Elemente Innenrohr 2, Funktionsschichten 3, 4, 6, 7, thermoelektrischen Grundelementen 5 und Außenrohr 8 keine anfälligen stoffschlüssigen Verbindungen eingesetzt. Dadurch werden Scherkräfte aufgrund axialer Längenänderungsunterschiede, typischerweise aufgrund thermischer Ausdehnung durch die Temperaturunterschiede von Heißseite und Kaltseite thermoelektrischer Module bedingt, durch die elastischen Funktionsschichten 3, 7 ausgeglichen. Durch die elastischen Eigenschaften können die Funktionsschichten 3, 7 thermischen oder mechanischen Einflüssen folgen, indem sie beispielsweise ein Fließverhalten zeigen oder elastische Verformungen tolerieren. Dies ermöglicht einen sehr flexiblen Einsatz der thermoelektrischen Module 1 sowohl mit einer außenliegenden als auch einer innenliegenden Heißseite.

Das Verfahren kann alternativ in umgekehrter Reihenfolge durchgeführt werden. Dazu wird zunächst in einem ersten Verfahrensschritt das Außenrohr 8 bereitgestellt. Anschließend werden die Funktionsschichten in Form von röhrenförmigen Folien 6, 7 in das Außenrohr 8 eingeschoben. Im Anschluss werden die thermoelektrischen Grundelemente 5, bevorzugt in Form mehrerer Streifen eingeschoben. In einem nächsten Schritt werden die inneren Funktionsschichten 3, 4 in Form von rohrförmigen Folien auf der Innenseite der thermoelektrischen Grundelemente 5 eingeschoben. Anschließend wird das Innenrohr 2 eingeschoben und aufgeweitet.

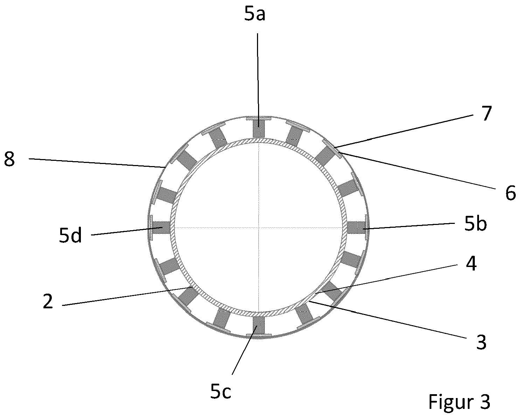

Figur 3 zeigt eine schematische Darstellung eines Querschnitts durch das thermoelektrische Modul 1.

Dargestellt sind die thermoelektrischen Grundelemente, beispielhaft gekennzeichnet mit den Bezugszeichen 5a, 5b, 5c, 5d, vorliegend 12 thermoelektrische Halbleiterelemente, die in Umfangsrichtung zwischen Innenrohr 2 und Außenrohr 8 angeordnet sind. Zwischen Innenrohr und thermoelektrischen Halbleiterelementen 5a, 5b, 5c, 5d ist die zweischichtige Funktionsschicht 3, 4 dargestellt. Zwischen thermoelektrischen Grundelementen 5a, 5b, 5c, 5d und Außenrohr 8 ist ebenfalls eine zweischichtige Funktionsschicht 6, 7 dargestellt.

Die beiden zweischichtigen Funktionsschichten sind vorliegend in Form einer Kapton^{®}-Folie 4, 6 und einer Graphitfolie 3, 7 ausgebildet. Die isolierende Kapton^{®}-Folie 4, 6 ist dabei jeweils auf der den thermoelektrischen Grundelementen 5 zugewandten Seite angeordnet.

Im Betriebszustand als thermoelektrischer Generator stellt das Innenrohr 2 vorteilhafterweise die Kaltseite dar, während außerhalb des Außenrohrs 8 die Heißseite liegt. Einem Betrieb in umgekehrter Wärmeflussrichtung steht allerdings nichts entgegen.

## Patentansprüche

1. Verfahren zur Herstellung eines thermoelektrischen Moduls (1) aus zumindest einem Innenrohr (2) und einem Außenrohr (8) und zumindest zwei thermoelektrischen Grundelementen (5), wobei das Verfahren die folgenden Verfahrensschritte umfasst:
A Bereitstellen des Innenrohrs (2),
B Bereitstellen des Außenrohrs (8),
C Bereitstellen der thermoelektrischen Grundelemente (5) außerhalb des Innenrohrs (2) oder innerhalb des Außenrohrs,
**dadurch gekennzeichnet,**
**dass** in einem Verfahrensschritt C0 zumindest eine erste plastisch oder elastisch verformbare Funktionsschicht (3, 7) zwischen Innenrohr (2) und thermoelektrischen Grundelementen (5) und eine zweite plastisch oder elastisch verformbare Funktionsschicht (3, 7) zwischen thermoelektrischen Grundelementen (5) und Außenrohr (8) aufgebracht wird und die thermoelektrischen Grundelemente (5) in Verfahrensschritt C mit ihrer Längserstreckung parallel zu der Längserstreckung des Innenrohrs (2) in Wirkverbindung mit der Funktionsschicht angeordnet werden,
und **dass** in einem Verfahrensschritt D nach dem Verfahrensschritt C0 das Innenrohr aufgeweitet wird, sodass durch das Aufweiten des Innenrohrs (2) ein Pressverband aus Innenrohr (2), Funktionsschichten (3, 7), thermoelektrischen Grundelementen (5) und Außenrohr (8) entsteht.

2. Verfahren nach Anspruch 1,
**dadurch gekennzeichnet,**
**dass** vor dem Verfahrensschritt D zumindest eine elektrisch isolierende Funktionsschicht (4, 6) zwischen Innenrohr (2) und thermoelektrischen Grundelementen (5) und/oder zwischen thermoelektrischen Grundelementen (5) und Außenrohr (8) aufgebracht wird.

3. Verfahren nach Anspruch 1 oder 2,
**dadurch gekennzeichnet,**
**dass** auf die thermoelektrischen Grundelemente (5) eine elektrisch isolierende Schicht aufgebracht wird.

4. Verfahren nach einem der vorangegangenen Ansprüche,
**dadurch gekennzeichnet,**
**dass** eine Presskraft zur Herstellung des Pressverbands in Verfahrensschritt D an eine maximale Betriebstemperatur des thermoelektrischen Moduls (1) angepasst ist, insbesondere dass der Pressverband ausgelegt ist, eine thermische Ausdehnung des Innenrohrs (2) und/oder des Außenrohrs (8) zu kompensieren.

5. Verfahren nach einem der vorangegangenen Ansprüche,
**dadurch gekennzeichnet,**
**dass** die Verbindung von Innenrohr (2), Funktionsschichten, thermoelektrischen Grundelementen (5) und Außenrohr (8) ohne eine stoffschlüssige Verbindung erfolgt.

6. Verfahren nach einem der vorangegangenen Ansprüche,
**dadurch gekennzeichnet,**
**dass** in dem Verfahrensschritt C eine Mehrzahl thermoelektrischer Grundelemente (5) gleichmäßig entlang des Umfangs des Innenrohrs (2) angebracht wird, vorzugsweise symmetrisch, insbesondere bevorzugt dass 12 thermoelektrische Grundelemente (5) gleichmäßig, radialsymmetrisch entlang des Umfangs des Innenrohrs (2) angebracht werden.

7. Verfahren nach einem der vorangegangenen Ansprüche,
**dadurch gekennzeichnet,**
**dass** eine Mehrzahl Funktionsschichten aufgebracht wird, insbesondere dass zwischen Innenrohr (2) und thermoelektrischen Grundelementen (5) eine erste plastisch oder elastisch verformbare Funktionsschicht (3) und eine zweite elektrisch isolierende Funktionsschicht (4) aufgebracht wird und/oder zwischen thermoelektrischen Grundelementen (5) und Außenrohr (8) eine erste elektrisch isolierende Funktionsschicht (6) und eine zweite plastisch oder elastisch verformbare Funktionsschicht (7) aufgebracht wird, vorzugsweise.

8. Verfahren nach einem der vorangegangenen Ansprüche,
**dadurch gekennzeichnet,**
**dass** die thermoelektrischen Grundelemente (5) kontaktiert werden, vorzugsweise dass die thermoelektrischen Grundelemente (5) miteinander elektrisch verbunden sind und eine gemeinsame Kontaktierung für die elektrisch verbundenen thermoelektrischen Grundelemente aufgebracht wird.

9. Thermoelektrisches Modul (1) mit zumindest einem Innenrohr (2) und einem Außenrohr (8) und zumindest zwei thermoelektrischen Grundelementen (5),
**dadurch gekennzeichnet,**
**dass** die thermoelektrischen Grundelemente (5) eine Längserstreckung parallel zu der Längserstreckung des Innenrohrs (2) aufweisen und das thermoelektrische Modul (1) zwischen Innenrohr (2) und thermoelektrischen Grundelementen (5) zumindest eine erste plastisch und/oder elastisch verformbare Funktionsschicht (3, 7) und zwischen thermoelektrischen Grundelementen (5) und Außenrohr (8) zumindest eine zweite plastisch und/oder elastisch verformbare Funktionsschicht (3, 7) aufweist und Innenrohr (2), Funktionsschichten (3, 7), thermoelektrische Grundelemente (5) und Außenrohr (8) mittels eines Pressverbands verbunden sind.

10. Thermoelektrisches Modul (1) nach Anspruch 9,
**dadurch gekennzeichnet,**
**dass** das thermoelektrische Modul (1) zwischen Innenrohr (2) und thermoelektrischen Grundelementen (5) und/oder zwischen thermoelektrischen Grundelementen (5) und Außenrohr (8) zumindest eine elektrisch isolierende Funktionsschicht (4, 6) aufweist.

11. Thermoelektrisches Modul (1) nach Anspruch 9 oder 10,
**dadurch gekennzeichnet, dass** die thermoelektrischen Grundelemente (5) zumindest eine elektrisch isolierende Schicht aufweisen.

12. Thermoelektrisches Modul (1) nach einem der Ansprüche 9 bis 11, **dadurch gekennzeichnet,**
**dass** die Funktionsschicht zumindest zweischichtig, bevorzugt in Form einer elektrisch isolierenden Funktionsschicht (4, 6) und einer plastisch oder elastisch verformbaren Funktionsschicht (3, 7) ausgebildet ist, insbesondere bevorzugt in Form einer Polyimid-Folie und einer Graphitfolie.

13. Thermoelektrisches Modul (1) nach einem der Ansprüche 9 bis 12, **dadurch gekennzeichnet,**
**dass** das thermoelektrische Modul (1) zwischen Innenrohr (2) und thermoelektrischen Grundelementen (5) eine erste elektrisch isolierende Funktionsschicht (4, 6) und eine zweite plastisch oder elastisch verformbaren Funktionsschicht (3, 7) aufweist und/oder zwischen thermoelektrischen Grundelementen (5) und Außenrohr (8) eine erste elektrisch isolierende Funktionsschicht (4, 6) und eine zweite plastisch oder elastisch verformbaren Funktionsschicht (3, 7) aufweist, vorzugsweise dass die erste elektrisch isolierende Funktionsschicht (3) und die thermoelektrischen Grundelementen (5) in direktem Kontakt stehen, insbesondere dass die erste elektrisch isolierende Funktionsschicht (3) und die thermoelektrischen Grundelementen (5) in direktem Kontakt stehen und eine zweite elektrisch isolierende Funktionsschicht (7) und die thermoelektrischen Grundelementen (5) auf der der ersten elektrisch isolierenden Funktionsschicht abgewandten Seite in direktem Kontakt stehen.

14. Thermoelektrisches Modul (1) nach einem der Ansprüche 9 bis 13, **dadurch gekennzeichnet,**
**dass** zumindest eine Klebeschicht, vorzugsweise zumindest zwei Klebeschichten vorgesehen sind, insbesondere bevorzugt, dass die Klebeschichten zwischen thermoelektrischen Grundelementen (5) und angrenzender Funktionsschicht auf der Kaltseite angeordnet sind.

15. Thermoelektrisches Modul (1) nach einem der Ansprüche 9 bis 14, **dadurch gekennzeichnet,**
**dass** die thermoelektrischen Grundelemente (5) aus p- und n-dotierten Halbleiterelementen aufgebaut sind, die elektrisch leitend miteinander verbunden sind.

16. Thermoelektrisches Modul (1) nach einem der Ansprüche 9 bis 15, **dadurch gekennzeichnet,**
**dass** eine Mehrzahl thermoelektrischer Grundelemente (5) vorgesehen ist, bevorzugt dass mehr als 10, insbesondere bevorzugt 18 thermoelektrische Grundelemente (5) gleichmäßig, radialsymmetrisch entlang des Umfangs des Innenrohrs (2) angebracht sind.

17. Thermoelektrisches Modul nach einem der Ansprüche 9 bis 16, **dadurch gekennzeichnet,**
**dass** in dem Innenrohr (2) ein Turbulator, insbesondere ein spiralförmiger, ein schraubenförmiger oder ein links/rechts-verdrehter Turbulator, vorgesehen ist.

18. Thermoelektrisches Modul nach einem der vorangegangenen Ansprüche 9 bis 17,
**dadurch gekennzeichnet,**
**dass** das Innenrohr (2) und/oder das Außenrohr (8) aus einer Formgedächtnislegierung ausgebildet ist.

19. Wärmetauscher mit zumindest einem thermoelektrischen Modul (1), einem Gehäuse, einer Fluidzufuhr auf der Heißseite und einer Fluidzufuhr auf der Kaltseite,
**dadurch gekennzeichnet,**
**dass** das thermoelektrische Modul (1) nach einem der vorangegangenen Ansprüche 9 bis 18 ausgebildet ist.

20. Thermoelektrischer Generator mit zumindest einem Wärmetauscher mit zumindest einem thermoelektrischen Modul (1),
**dadurch gekennzeichnet,**
**dass** das thermoelektrische Modul (1) nach einem der vorangegangenen Ansprüche 9 bis 18 ausgebildet ist.

21. Kühlvorrichtung, insbesondere ein Peltier-Modul, mit zumindest einem Wärmetauscher mit zumindest einem thermoelektrischen Modul (1), **dadurch gekennzeichnet,**
**dass** das thermoelektrische Modul (1) nach einem der vorangegangenen Ansprüche 9 bis 18 ausgebildet ist.

22. Verwendung eines thermoelektrischen Moduls (1) als Aktor,
**dadurch gekennzeichnet,**
**dass** das thermoelektrische Modul (1) nach einem der vorangegangenen Ansprüche 9 bis 18 ausgebildet ist.

## Claims

1. Method for producing a thermoelectric module (1) from at least an inner tube (2) and an outer tube (8) and at least two thermoelectric base elements (5), wherein the method comprises the following method steps:
A providing the inner tube (2),
B providing the outer tube (8),
C providing the thermoelectric base elements (5) outside the inner tube (2) or inside the outer tube,
**characterized in that**, in a method step CO, at least one plastically or elastically deformable functional layer (3, 7) is applied between inner tube (2) and thermoelectric base elements (5) and a second plastically or elastically deformable functional layer (3, 7) is applied between thermoelectric base elements (5) and outer tube (8) and the thermoelectric base elements (5) in method step C are arranged with their longitudinal extent parallel to the longitudinal extent of the inner tube (2) and operatively connected to the functional layer,
and **in that** in a method step D after the method step CO, the inner tube is widened, such that the widening of the inner tube (2) gives rise to an interference fit assembly composed of inner tube (2), functional layers (3, 7), thermoelectric base elements (5) and outer tube (8).

2. Method according to claim 1,
**characterized in that**
prior to method step D, at least one electrically insulating functional layer (4, 6) is applied between inner tube (2) and thermoelectric base elements (5) and/or between thermoelectric base elements (5) and outer tube (8).

3. Method according to claim 1 or 2,
**characterized in that**
an electrically insulating layer is applied to the thermoelectric base elements (5).

4. Method according to any one of the preceding claims,
**characterized in that**
a pressing force for producing the interference fit assembly in method step D is matched to a maximum operating temperature of the thermoelectric module (1), in particular **in that** the interference fit assembly is designed to compensate for any thermal expansion of the inner tube (2) and/or the outer tube (8).

5. Method according to any one of the preceding claims,
**characterized in that**
inner tube (2), functional layers, thermoelectric base elements (5) and outer tube (8) are connected without an integral bond.

6. Method according to any one of the preceding claims,
**characterized in that**
in the method step C, a multitude of thermoelectric base elements (5) is mounted uniformly along the circumference of the inner tube (2), preferably symmetrically, particularly preferably **in that** 12 thermoelectric base elements (5) are mounted uniformly, in a radially symmetric manner along the circumference of the inner tube (2).

7. Method according to any one of the preceding claims,
**characterized in that**
a multitude of functional layers is applied, in particular **in that** a first plastically or elastically deformable functional layer (3) and a second electrically insulating functional layer (4) are applied between inner tube (2) and thermoelectric base elements (5), and/or a first electrically insulating functional layer (6) and a second plastically or elastically deformable functional layer (7) are applied between thermoelectric base elements (5) and outer tube (8), preferably.

8. Method according to any one of the preceding claims,
**characterized in that**
the thermoelectric base elements (5) are contact-connected, preferably **in that** the thermoelectric base elements (5) are electrically connected to one another and a common contact connection is applied for the electrically connected thermoelectric base elements.

9. Thermoelectric module (1) with at least an inner tube (2) and an outer tube (8) and at least two thermoelectric base elements (5),
**characterized in that**
the thermoelectric base elements (5) have a longitudinal extent parallel to the longitudinal extent of the inner tube (2) and the thermoelectric module (1) has at least one plastically and/or elastically deformable functional layer (3, 7) between inner tube (2) and thermoelectric base elements (5) and has a second plastically and/or elastically deformable functional layer (3, 7) between thermoelectric base elements (5) and outer tube (8), and inner tube (2), functional layers (3, 7), thermoelectric base elements (5) and outer tube (8) are connected by means of an interference fit assembly.

10. Thermoelectric module (1) according to claim 9,
**characterized in that**
the thermoelectric module (1) has at least one electrically insulating functional layer (4, 6) between inner tube (2) and thermoelectric base elements (5) and/or between thermoelectric base elements (5) and outer tube (8).

11. Thermoelectric module (1) according to claim 9 or 10,
**characterized in that**
the thermoelectric base elements (5) have at least one electrically insulating layer.

12. Thermoelectric module (1) according to any one of claims 9 to 11,
**characterized in that**
the functional layer is in at least two-layer form, preferably in the form of an electrically insulating functional layer (4, 6) and a plastically or elastically deformable functional layer (3, 7), particularly preferably in the form of a polyimide film and a graphite film.

13. Thermoelectric module (1) according to any one of claims 9 to 12,
**characterized in that**
the thermoelectric module (1) has a first electrically insulating functional layer (4, 6) and a second plastically or elastically deformable functional layer (3, 7) between inner tube (2) and thermoelectric base elements (5) and/or has a first electrically insulating functional layer (4, 6) and a second plastically or elastically deformable functional layer (3, 7) between thermoelectric base elements (5) and outer tube (8), preferably **in that** the first electrically insulating functional layer (3) and the thermoelectric base elements (5) are in direct contact, in particular **in that** the first electrically insulating functional layer (3) and the thermoelectric base elements (5) are in direct contact and a second electrically insulating functional layer (7) and the thermoelectric base elements (5) on the side remote from the first electrically insulating functional layer are in direct contact.

14. Thermoelectric module (1) according to any one of claims 9 to 13,
**characterized in that**
at least one adhesive layer, preferably at least two adhesive layers, are provided, particularly preferably **in that** the adhesive layers are disposed on the cold side between thermoelectric base elements (5) and adjoining functional layer.

15. Thermoelectric module (1) according to any one of claims 9 to 14,
**characterized in that**
the thermoelectric base elements (5) are formed from p- and n-doped semiconductor elements that are connected to one another in an electrically conductive manner.

16. Thermoelectric module (1) according to any one of claims 9 to 15,
**characterized in that**
a multitude of thermoelectric base elements (5) is provided, preferably **in that** more than 10, particularly preferably 18, thermoelectric base elements (5) are mounted uniformly, in a radially symmetric manner along the circumference of the inner tube (2).

17. The optical module according to any one of claims 9 to 16,
**characterized in that**
a turbulator, in particular a turbulator in spiral form or in screw form, or a left/right-twisted turbulator, is provided in the inner tube (2).

18. Thermoelectric module according to any one of claims 9 to 17,
**characterized in that**
the inner tube (2) and/or the outer tube (8) is formed from a shape-memory alloy.

19. Heat exchanger with at least one thermoelectric module (1), a housing, a fluid feed on the hot side and a fluid feed on the cold side,
**characterized in that**
the thermoelectric module (1) is formed according to any one of the preceding claims 9 to 18.

20. Thermoelectric generator with at least one heat exchanger with at least one thermoelectric module (1),
**characterized in that**
the thermoelectric module (1) is formed according to any one of the preceding claims 9 to 18.

21. Cooling device, in particular a Peltier module, with at least one heat exchanger with at least one thermoelectric module (1),
**characterized in that**
the thermoelectric module (1) is formed according to any one of the preceding claims 9 to 18.

22. Use of a thermoelectric module (1) as an actuator,
**characterized in that**
the thermoelectric module (1) is formed according to any one of the preceding claims 9 to 18.

## Revendications

1. Procédé de fabrication d'un module thermoélectrique (1) constitué d'au moins un tube intérieur (2) et d'un tube extérieur (8) et d'au moins deux éléments de base thermoélectriques (5), dans lequel le procédé comprend les étapes de procédé suivantes :
A fourniture du tube intérieur (2),
B fourniture du tube extérieur (8),
C fourniture des éléments de base thermoélectriques (5) à l'extérieur du tube intérieur (2) ou à l'intérieur du tube extérieur,
**caractérisé en ce que**, dans une étape C0 du procédé, au moins une première couche fonctionnelle plastiquement ou élastiquement déformable (3, 7) est appliquée entre le tube intérieur (2) et les éléments de base thermoélectriques (5) et une seconde couche fonctionnelle plastiquement ou élastiquement déformable (3, 7) est appliquée entre les éléments de base thermoélectriques (5) et le tube extérieur (8), et les éléments de base thermoélectriques (5) sont disposés dans l'étape de procédé C avec leur extension longitudinale parallèle à l'extension longitudinale du tube intérieur (2) en liaison active avec la couche fonctionnelle,
et **en ce que**, dans une étape D du procédé, après l'étape C0 du procédé, le tube intérieur est élargi de sorte que l'élargissement du tube intérieur (2) crée un emmanchement à force du tube intérieur (2), des couches fonctionnelles (3, 7), des éléments de base thermoélectriques (5) et du tube extérieur (8).

2. Procédé selon la revendication 1,
**caractérisé en ce que**
avant l'étape D du procédé, au moins une couche fonctionnelle électriquement isolante (4, 6) est appliquée entre le tube intérieur (2) et les éléments de base thermoélectriques (5) et/ou entre les éléments de base thermoélectriques (5) et le tube extérieur (8).

3. Procédé selon la revendication 1 ou 2,
**caractérisé en ce que**
une couche électriquement isolante est appliquée sur les éléments de base thermoélectriques (5).

4. Procédé selon l'une quelconque des revendications précédentes,
**caractérisé en ce que**
une force de pression pour la fabrication de l'emmanchement à force à l'étape D du procédé est adaptée à une température de fonctionnement maximale du module thermoélectrique (1), en particulier **en ce que** l'emmanchement à force est conçu pour compenser une dilatation thermique du tube intérieur (2) et/ou du tube extérieur (8).

5. Procédé selon l'une quelconque des revendications précédentes,
**caractérisé en ce que**
la connexion du tube intérieur (2), des couches fonctionnelles, des éléments de base thermoélectriques (5) et du tube extérieur (8) s'effectue sans connexion par complémentarité de matière.

6. Procédé selon l'une quelconque des revendications précédentes,
**caractérisé en ce que**
à l'étape C du procédé, une pluralité d'éléments de base thermoélectriques (5) est appliquée uniformément le long de la circonférence du tube intérieur (2), de préférence symétriquement, en particulier de préférence **en ce que** 12 éléments de base thermoélectriques (5) sont appliqués uniformément, à symétrie radiale, le long de la circonférence du tube intérieur (2).

7. Procédé selon l'une quelconque des revendications précédentes,
**caractérisé en ce que**
une pluralité de couches fonctionnelles est appliquée, en particulier **en ce qu'**une première couche fonctionnelle plastiquement ou élastiquement déformable (3) et une seconde couche fonctionnelle électriquement isolante (4) sont appliquées entre le tube intérieur (2) et les éléments de base thermoélectriques (5) et/ou une première couche fonctionnelle électriquement isolante (6) et une seconde couche fonctionnelle plastiquement ou élastiquement déformable (7) sont appliquées de préférence entre les éléments de base thermoélectriques (5) et le tube extérieur (8).

8. Procédé selon l'une quelconque des revendications précédentes,
**caractérisé en ce que**
les éléments de base thermoélectriques (5) sont mis en contact, de préférence **en ce que** les éléments de base thermoélectriques (5) sont connectés électriquement entre eux et **en ce qu'**une mise en contact commune est appliquée pour les éléments de base thermoélectriques connectés électriquement.

9. Module thermoélectrique (1) avec au moins un tube intérieur (2) et un tube extérieur (8) et au moins deux éléments de base thermoélectriques (5),
**caractérisé en ce que**
les éléments de base thermoélectriques (5) présentent une extension longitudinale parallèle à l'extension longitudinale du tube intérieur (2), et le module thermoélectrique (1) présente entre le tube intérieur (2) et les éléments de base thermoélectriques (5) au moins une première couche fonctionnelle plastiquement et/ou élastiquement déformable (3, 7) et, entre les éléments de base thermoélectriques (5) et le tube extérieur (8), au moins une seconde couche fonctionnelle plastiquement et/ou élastiquement déformable (3, 7), et le tube intérieur (2), les couches fonctionnelles (3, 7), les éléments de base thermoélectriques (5) et le tube extérieur (8) sont connectés au moyen d'un emmanchement par force.

10. Module thermoélectrique (1) selon la revendication 9,
**caractérisé en ce que**
le module thermoélectrique (1) présente au moins une couche fonctionnelle électriquement isolante (4, 6) entre le tube intérieur (2) et les éléments de base thermoélectriques (5) et/ou entre les éléments de base thermoélectriques (5) et le tube extérieur (8).

11. Module thermoélectrique (1) selon la revendication 9 ou 10,
**caractérisé en ce que**
les éléments de base thermoélectriques (5) présentent au moins une couche électriquement isolante.

12. Module thermoélectrique (1) selon l'une quelconque des revendications 9 à 11, **caractérisé en ce que**
la couche fonctionnelle est formée d'au moins deux couches, de préférence sous forme d'une couche fonctionnelle électriquement isolante (4, 6) et d'une couche fonctionnelle plastiquement ou élastiquement déformable (3, 7), en particulier de préférence sous forme d'un film de polyimide et d'un film de graphite.

13. Module thermoélectrique (1) selon l'une quelconque des revendications 9 à 12, **caractérisé en ce que**
le module thermoélectrique (1) présente entre le tube intérieur (2) et les éléments de base thermoélectriques (5) une première couche fonctionnelle électriquement isolante (4, 6) et une seconde couche fonctionnelle plastiquement ou élastiquement déformable (3, 7) et/ou, entre les éléments de base thermoélectriques (5) et le tube extérieur (8), une première couche fonctionnelle électriquement isolante (4, 6) et une seconde couche fonctionnelle plastiquement ou élastiquement déformable (3, 7), de préférence **en ce que** la première couche fonctionnelle électriquement isolante (3) et les éléments de base thermoélectriques (5) sont en contact direct, en particulier **en ce que** la première couche fonctionnelle électriquement isolante (3) et les éléments de base thermoélectriques (5) sont en contact direct et une seconde couche fonctionnelle électriquement isolante (7) et les éléments de base thermoélectriques (5) sont en contact direct sur le côté opposé à la première couche fonctionnelle électriquement isolante.

14. Module thermoélectrique (1) selon l'une quelconque des revendications 9 à 13, **caractérisé en ce que**
au moins une couche de collage, de préférence au moins deux couches de collage, sont prévues, de préférence en particulier **en ce que** les couches de collage sont disposées entre les éléments de base thermoélectriques (5) et la couche fonctionnelle adjacente sur le côté froid.

15. Module thermoélectrique (1) selon l'une quelconque des revendications 9 à 14, **caractérisé en ce que**
les éléments de base thermoélectriques (5) sont constitués d'éléments semiconducteurs à dopage p et n, qui sont connectés entre eux de manière électriquement conductrice.

16. Module thermoélectrique (1) selon l'une quelconque des revendications 9 à 15, **caractérisé en ce que**
une pluralité d'éléments de base thermoélectriques (5) est prévue, de préférence **en ce que** plus de 10, en particulier de préférence 18 éléments de base thermoélectriques (5), sont appliqués uniformément à symétrie radiale le long de la circonférence du tube intérieur (2).

17. Module thermoélectrique selon l'une quelconque des revendications 9 à 16, **caractérisé en ce que**
un turbulateur, en particulier un turbulateur en forme de spirale, un turbulateur en forme d'hélice ou un turbulateur à torsion gauche/droite, est prévu dans le tube intérieur (2).

18. Module thermoélectrique selon l'une quelconque des revendications précédentes 9 à 17,
**caractérisé en ce que**
le tube intérieur (2) et/ou le tube extérieur (8) est formé d'un alliage à mémoire de forme.

19. Échangeur de chaleur avec au moins un module thermoélectrique (1), un boîtier, une alimentation en fluide du côté chaud et une alimentation en fluide du côté froid,
**caractérisé en ce que**
le module thermoélectrique (1) est conçu selon l'une quelconque des revendications précédentes 9 à 18.

20. Générateur thermoélectrique avec au moins un échangeur de chaleur avec au moins un module thermoélectrique (1),
**caractérisé en ce que**
le module thermoélectrique (1) est conçu selon l'une quelconque des revendications précédentes 9 à 18.

21. Dispositif de refroidissement, en particulier un module Peltier, avec au moins un échangeur de chaleur avec au moins un module thermoélectrique (1),
**caractérisé en ce que**
le module thermoélectrique (1) est conçu selon l'une quelconque des revendications précédentes 9 à 18.

22. Utilisation d'un module thermoélectrique (1) en tant qu'actionneur, **caractérisé en ce que**
le module thermoélectrique (1) est conçu selon l'une quelconque des revendications précédentes 9 à 18.
